# EUROPEAN PATENT APPLICATION

(11) **EP 4 343 435 A1**
(43) Date of publication of application: **27.03.2024**
(21) Application number: 22804869.0
(22) Date of filing: 03.05.2022
(51) Int. Cl.: G03F 7/11, G03F 7/16, C08L 65/00, C08L 61/02

(54) **SPIN-ON CARBON HARD MASK COMPOSITION HAVING LOW EVAPORATION LOSS, AND PATTERNING METHOD USING SAME**

(30) Priority: 17.05.2021 KR 20210063102
(71) Applicant: Ycchem Co., Ltd., Gyeongsangbuk-do 40046 (KR)
(72) Inventor: LEE, Su Jin, Daegu 42634 (KR); KIM, Gi Hong, Daegu 41808 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2022/006311
(87) International publication number: WO 2022/245014

(57) **Abstract**

The objective is to provide a spin-on hardmask composition exhibiting a small evaporation loss and being suitable for use in a semiconductor photolithography process which means to provide a composition containing a polymer represented by Formula 1, a surfactant, and an organic solvent and a patterning method using the same composition. The hardmask produced by the method has the effect of a yield improvement with excellent heat resistance by minimizing evaporation loss which is a cause of defects in a process.

## Description

### Technical Field

The present disclosure relates to a hardmask composition having small evaporation loss and being suitable for use in a semiconductor lithography process. The composition has excellent heat resistance and thus exhibits a minimized evaporation loss wherein the evaporation loss is a cause of defects during a process. The present disclosure also relates to a patterning method using the same composition.

### Background Art

Lately, there has been a growing demand for the formation of fine patterns due to the downscaling and integration of semiconductor devices. To form fine patterns, it is efficient to refine photoresist patterns by developing exposure equipment or introducing additional processes.

As a method to increase the circuit density of semiconductor devices and form a structure with nanometer-scale dimensions, tools for photoresist development or photolithography for the achievement of a high resolution have been developed.

In processing for manufacturing semiconductors, patterns were formed on a semiconductor substrate by using an i-line light source with a wavelength of 365 nm in the past, but light sources with a shorter wavelength have been required to form a finer pattern.

In fact, lithography techniques using KrF (248 nm), ArF (193 nm), and EUV (extreme ultraviolet, 13.5 nm) light sources have been developed and are now commercially available or in the process of being commercialized, enabling even finer wavelengths to be used in reality.

Along with a pattern becoming smaller, the thickness of the photoresists has been thinner to prevent the pattern collapse of the photoresists. A layer to be etched was not able to be etched by using the thinned photoresist pattern so that a layer with an excellent etching resistance became inserted between a photoresist layer and a layer to be etched, and the inserted layer started to be called a hardmask. Hardmask process refers to forming a hardmask through etching by using a photoresist pattern for patterning before etching the layer to be etched by using a hardmask pattern. The hardmask layer is manufactured through chemical vapor deposition (CVD) or spin-on coating.

CVD for manufacturing a hardmask layer has limitations of increases in upfront cost and process time due to the use of a deposition device and particles-related issues. Thus, efforts have been made to reduce the cost and process time in manufacturing a hardmask layer by using materials capable of spin coating instead of using deposition.

Spin-on coating for manufacturing a hardmask layer has the advantages of a lower upfront cost than that of CVD, even coating ability, ease of controlling the thickness of coating, and shortened process time.

Against this backdrop, lately, the more downscaled of semiconductor process has become, the narrower a bar has become, but the height has not changed or relatively increased so that the aspect ratio of the pattern has risen. The higher hardmask layer leads to a more evaporation during baking process and an occurrence of defects so that the problem of a low yield occurs. Thus, there is a demand for the development of a new material for a hardmask layer to improve the yield by minimizing evaporation loss which is a cause of defects.

### [Related Art Documents]

### [Patent Document]

Patent Document 1. Korean Patent No. 10-1777687(2017. 09. 12.)
Patent Document 2. Korean Patent No. 10-2240213(2021. 04. 14.)

### Disclosure

### Technical Problem

The present disclosure relates to a spin-on carbon hardmask composition and a patterning method by using the same composition in the semiconductor manufacturing process and aims to provide a spin-on carbon hardmask composition capable of minimizing evaporation loss which is a cause of defects and to provide a patterning method by using the composition.

### Technical Solution

According to one embodiment of the present disclosure, the spin-on carbon hardmask composition has the structure formula represented by Formula 1 below and a weight average molecular weight in a range of 1,500 to 20,000, the composition having a minimized evaporation loss.

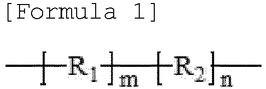

In the formula, m and n are in ranges of 1≤m≤50 and 1≤n≤50, respectively,
R₁ includes
any one of 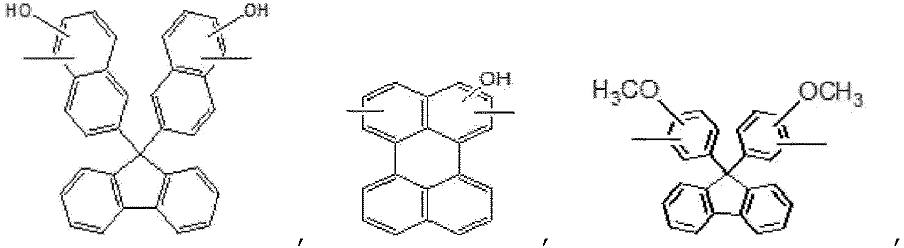 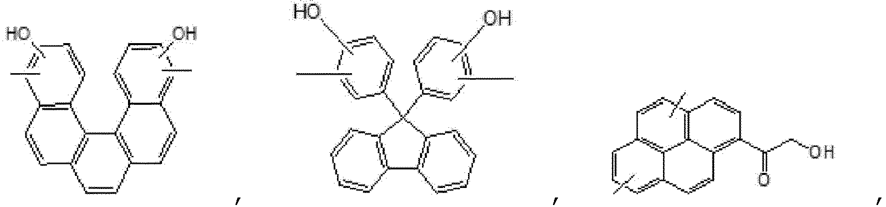 and 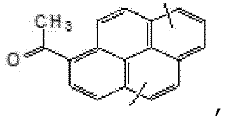 and
R₂ includes
any one of

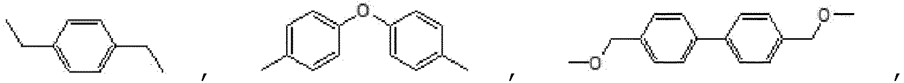

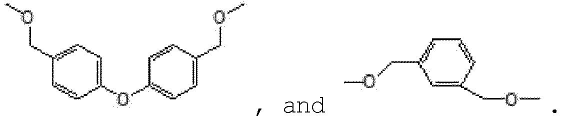

According to one embodiment of the present disclosure, the hardmask composition includes the polymer represented by Formula 1 in an amount of 1% to 50% by weight, an organic solvent in an amount of 50% to 98.99% by weight, and a surfactant in an amount of 0.01% to 0.1% by weight based on the total weight of the composition and represented by Formula 1.

According to one embodiment of the present disclosure, the organic solvent may be one or a mixture of two or more selected from the group consisting of propylenecyclocholomonomethylethers (PGMEs), propyleneglycolomonomethyletheracetates (PGMEAs), cyclohexanones, cyclopentanones, γ-butyrolactones, ethyllactates (ELs), methylethylketone, n-butylacetates, N-methylpyrrolidones (NMPs), methyl 3-methoxypropionates (MMPs), ethyl 3-ethoxypropionates (EEPs).

According to one embodiment of the present disclosure, the surfactant may be any one or a mixture of two or more selected from nonionic surfactants such as polyoxyethylenealkylethers, polyoxyethylenealkylphenylethers, polyoxyethylenenonylphenylethers, polyoxyethyleneoctylphenylethers, polyoxyethylenepolyoxypropylenes, polyoxyethylenelaurylethers, and polyoxyethylenesorbitans.

According to one embodiment of the present disclosure, there is provided a patterning method including: applying the composition to a surface of a layer to be etched through spin coating; and baking the applied composition to form a hardmask-filmed layer.

According to one embodiment of the present disclosure, the baking is performed at a temperature in a range of 150°C to 400°C for 1 minute to 5 minutes to form a pattern.

### Advantageous Effects

A hardmask composition capable of minimizing evaporation loss, according to the present disclosure, has excellent heat resistance so that evaporation loss can be minimized, and thus the occurrence of defects can be reduced. The hardmask composition also has high etching selectivity and sufficient resistance against multi-etching, thereby exhibiting excellent performance when it is used to form fine patterns of a semiconductor device.

### Description of Drawings

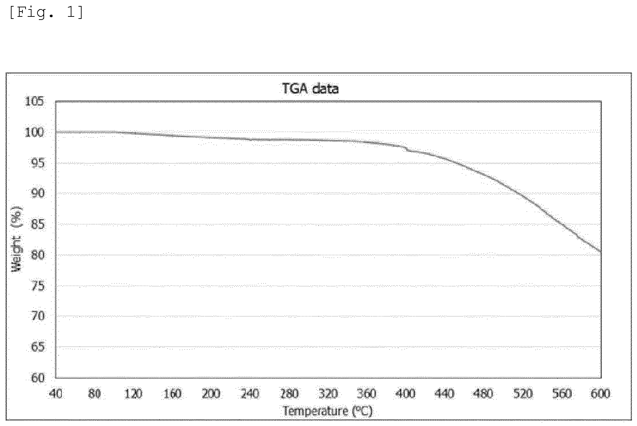

FIG. 1 is a TGA spectrum of a polymer prepared in Example 1.

### Best Mode

Hereinafter, the present disclosure will be described in more detail.

The present disclosure relates to a spin-on carbon hardmask composition having a structure represented by Formula 1 and having a weight average molecular weight in a range of 1,500 to 20,000, preferably a range of 1,500 to 15,000, and more preferably a range of 1,500 to 10,000.

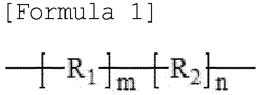

In the formula, m and n are in ranges of 1≤m≤50 and 1≤n≤50, respectively,
R₁ includes
any one of 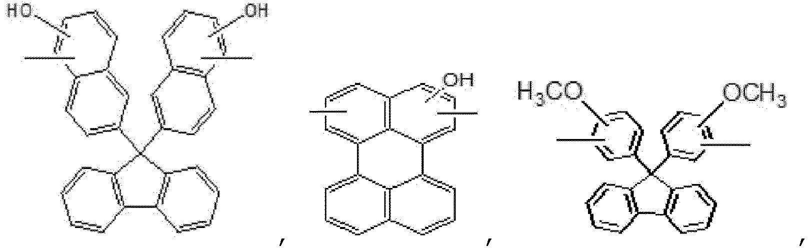 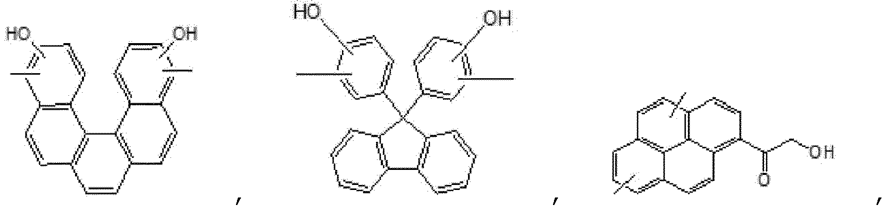 and 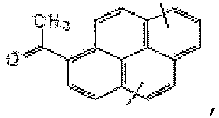 and
R₂ includes
any one of

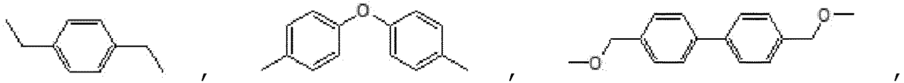

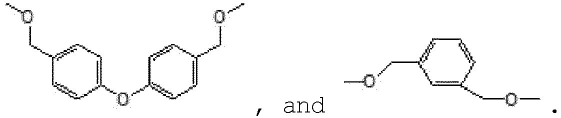

In the formula, R₁ largely serves to improve the thermal-curing behaviors and etch selectivity of the total polymer structure.

In the formula, R₂ largely serves to increase the flowability and coatability of the prepared polymer materials under the presence of an acidic catalyst.

The polymer represented by Formula 1 has a weight average molecular weight in a range of 1,500 to 20,000, preferably a range of 1,500 to 15,000, more preferably a range of 1,500 to 10,000.

When the weight average molecular weight of the polymer represented by Formula 1 is less than 1,500, a polymer structure in a sufficient amount is not formed so that etching resistance is reduced. When the weight average molecular weight of the polymer represented by Formula 1 is more than 20,000, the physical properties of the coated surface may be uneven.

The hardmask composition may include the polymer represented by Formula in an amount of 1% to 50% by weight, an organic solvent in an amount of 50% to 98.99% by weight, and a surfactant in an amount of 0.01% to 0.1% by weight based on the total weight thereof.

Herein, when the content of the polymer is less than 1% by weight or more than 50% by weight, a formed coating may have a thickness smaller or larger than a predetermined value. That is, it is difficult to achieve a targeted coating thickness. When the coating thickness exceeds a predetermined value, the coating property of the composition may be deteriorated.

The organic solvent may be one or a mixture of two or more selected from the group consisting of propylenecyclocholomonomethylethers (PGMEs), propyleneglycolomonomethyletheracetates (PGMEAs), cyclohexanones, cyclopentanones, γ-butyrolactones, ethyllactates (ELs), methylethylketones, n-butylacetates, N-methylpyrrolidones (NMPs), methyl 3-methoxypropionates (MMPs), and ethyl 3-ethoxypropionates (EEPs) .

The surfactant for use may be one or a mixture of two or more selected from nonionic surfactants such as polyoxyethylenealkylethers, polyoxyethylenealkylphenylethers, polyoxyethylenenonylphenylethers, polyoxyethyleneoctylphenylethers, polyoxyethylenepolyoxypropylenes, polyoxyethylenelaurylethers, and polyoxyethylenesorbitans.

The surfactant reduces surface tension to increase spreadability or permeation, which can help with coatability or gap-filling performance.

According to another embodiment of the present disclosure, there is provided a patterning method including: applying the composition to the surface of a layer to be etched through spin coating; and baking the composition to form a hardmask layer.

A layer formed by spin coating the composition may have a thickness in a range of 135 to 2,200 nm. When the thickness is smaller than 135 nm, the layer to be etched cannot be sufficiently coated, so that etching resistance is reduced. On the other hand, when the thickness is larger than 2,200 nm, the physical properties of the coated surface are uneven resulting in deteriorated coatability. Therefore, such an excessively large thickness cannot be adopted.

The baking process may be performed at a temperature in a range of 150°C to 400°C for 1 minute to 5 minutes. In the baking process, the composition may cause a self-crosslinking reaction.

### Mode for Disclosure

Reference will now be made in greater detail to preferred examples and comparative examples of the disclosure. However, the following examples are just illustrative, and the present disclosure is not limited to the examples set forth herein.

### Example 1

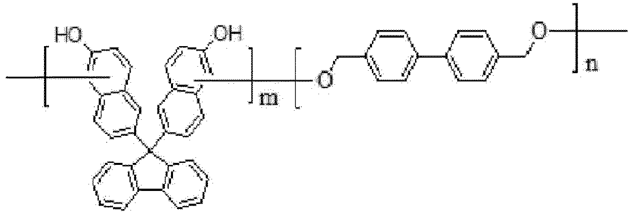

40 g of 9,9-bis(6-hydroxy-2-naphthyl)fluorene, 16 g of 4,4-bismethoxymethylbiphenyl, and 150 g of propyleneglycolmonomethylether acetate (PGMEA) were placed, and a nitrogen atmosphere was created. 0.20 g of diethylsulfate was added thereto, and the solution was heated to a temperature of 140°C and refluxed for 10 hours. After the reaction was completed, the solution was purified with a solution of hexane, ethanol, and water (1:1:1), recrystallized using a solution of ethanol and water (10:1), and vacuum-dried to obtain a polymer compound having a weight average molecular weight (Mw) of 5,000 measured through GPC (standard polystyrene conversion).

### Example 2

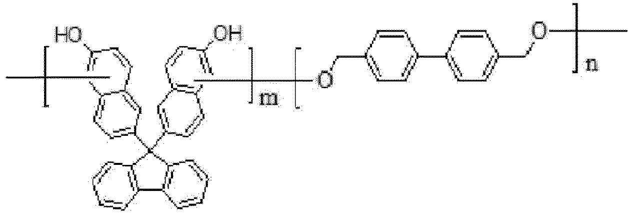

A polymer compound was synthesized in the same manner as in Example 1, except that a solution was heated to 140°C and then refluxed for 5 hours. The polymer compound had a weight average molecular weight (Mw) of 1,500 when measured through GPC (standard polystyrene conversion).

### Example 3

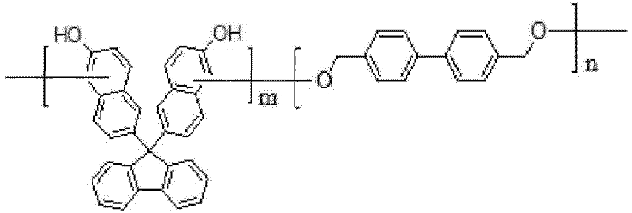

A polymer compound was synthesized in the same manner as in Example 1, except that 0.40 g of diethylsulfate was added, the solution was heated to 140°C, and the solution was refluxed for 20 hours. The polymer compound had a weight average molecular weight (Mw) of 10,000 when measured through GPC (standard polystyrene conversion).

### Example 4

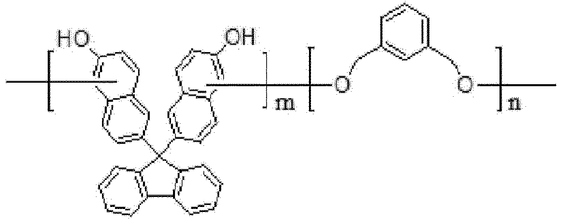

A polymer compound was synthesized in the same manner as in Example 1, except that 11 g of 1,3-bismethoxymethylbenzene was added instead of 4,4-bismethoxymethylbiphenyl. The obtained polymer compound had a weight average molecular weight (Mw) of 4,500 when measured through GPC (standard polystyrene conversion).

### Example 5

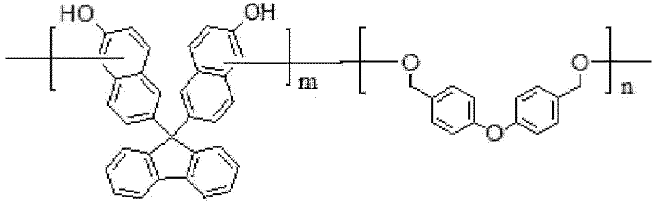

A polymer compound was synthesized in the same manner as in Example 1, except that 13 g of bismethoxymethylbiphenylether was added instead of 4,4-bismethoxymethylbiphenyl. The obtained polymer compound had a weight average molecular weight (Mw) of 5,200 when measured through GPC (standard polystyrene conversion).

### Comparative Example 1

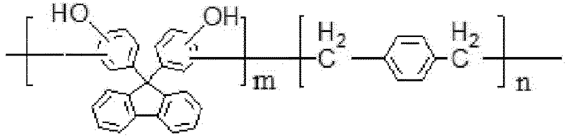

70 g of PGMEA was added to 20 g of 9,9-bis(4-hydroxyphenyl)fluorene and 9.5 g of 1,4-bismethoxymethylbenzene, and then 0.20 g of diethylsulfate was added thereto. After synthesizing a polymer compound in the same method as in Example 1, the weight average molecular weight (Mw) of the obtained polymer compound had a weight average molecular weight of 4,900 measured through GPC (standard polystyrene conversion).

### Comparative Example 2

A polymer compound was synthesized in the same manner as in Comparative Example 1, except that the reaction time was 5 hours. The obtained polymer compound had a weight average molecular weight (Mw) of 1,500 measured through GPC (standard polystyrene conversion).

### Comparative Example 3

A polymer compound was synthesized in the same manner as in Comparative Example 1, except that the reaction time was 30 hours. The weight average molecular weight (Mw) of the obtained polymer compound was 21,000 measured through GPC (standard polystyrene conversion).

### Experimental Example 1

3.0g of the polymer compound obtained in Example 1, 37.55 g of propyleneglycolmonomethyletheracetate, 9.4 g of cyclohexanone, and 0.05 g of polyoxyethylenealkylether were added thereto and agitated for 20 hours to have the substances dissolved. After filtering the solution with a 0.2-pm fine filter, a composition for forming a hardmask film was prepared. The composition was applied to the surface of a silicon wafer with a spin-coater. The composition was heated on a hot plate at a temperature of 240°C for 1 minute and then sequentially at a temperature of 400°C for 1 minute to obtain a hardmask film.

### Experimental Example 2

A hardmask film was obtained in the same manner as in Experimental Example 1, except that the polymer compound obtained in Example 2 was used in an amount of 3.0 g.

### Experimental Example 3

A hardmask film was obtained in the same manner as in Experimental Example 1, except that the polymer compound obtained in Example 3 was used in an amount of 3.0 g.

### Experimental Example 4

A hardmask film was obtained in the same manner as in Experimental Example 1, except that the polymer compound obtained in Example 4 was used in an amount of 3.0 g.

### Experimental Example 5

A hardmask film was obtained in the same manner as in Experimental Example 1, except that the polymer compound obtained in Example 5 was used in an amount of 3.0 g.

### Experimental Example 6

A hardmask film was obtained in the same manner as in Experimental Example 1, except that 17.0 g of the polymer compound obtained in Example 1, 26.35 g of propyleneglycolmonomethyletheracetate, 6.6 g of cyclohexanone, and 0.05 g of polyoxyethylenealkylether were used.

### Experimental Example 7

A hardmask film was obtained in the same manner as in Experimental Example 6, except that the polymer compound obtained in Example 2 was used in an amount of 17 g.

### Experimental Example 8

A hardmask film was obtained in the same manner as in Experimental Example 6, except that the polymer compound obtained in Example 3 was used in an amount of 17.0 g.

### Experimental Example 9

A hardmask film was obtained in the same manner as in Experimental Example 6, except that the polymer compound obtained in Example 4 was used in an amount of 17.0 g.

### Experimental Example 10

A hardmask film was obtained in the same manner as in Experimental Example 6, except that the polymer compound obtained in Example 5 was used in an amount of 17.0 g.

### Experimental Example 11

A hardmask film was obtained in the same manner as in Experimental Example 1, except that 3.0 g of the polymer compound obtained in Example 1, 37.575 g of propyleneglycolmonomethyletheracetate, 9.4 g of cyclohexanone, and 0.025 g of polyoxyethylenealkylether were used.

### Experimental Example 12

A hardmask film was obtained in the same manner as in Experimental Example 1, except that 3.0 g of the polymer compound obtained in Example 1, 37.595 g of propyleneglycolmonomethyletheracetate, 9.4 g of cyclohexanone, and 0.005 g of polyoxyethylenealkylether were used.

### Comparative Experimental Example 1

A hardmask film was obtained in the same manner as in Experimental Example 1, except that the polymer compound obtained in Comparative Example 1 was used in an amount of 3.0 g.

### Comparative Experimental Example 2

A hardmask film was obtained in the same manner as in Experimental Example 1, except that the polymer compound obtained in Comparative Example 2 was used in an amount of 3.0 g.

### Comparative Experimental Example 3

A hardmask film was obtained in the same manner as in Experimental Example 1, except that the polymer compound obtained in Comparative Example 3 was used in an amount of 3.0 g.

### Comparative Experimental Example 4

A hardmask film was obtained in the same manner as in Experimental Example 6, except that the polymer compound obtained in Comparative Example 1 was used in an amount of 17.0 g.

### Comparative Experimental Example 5

A hardmask film was obtained in the same manner as in Experimental Example 6, except that the polymer compound obtained in Comparative Example 2 was used in an amount of 17.0 g.

### Comparative Experimental Example 6

A hardmask film was obtained in the same manner as in Experimental Example 6, except that the polymer compound obtained in Comparative Example 3 was used in an amount of 17.0 g.

### Comparative Experimental Example 7

A hardmask film was obtained in the same manner as in Experimental Example 1, except that 17.0 g of the polymer compound obtained in Example 1, 26.4 g of propyleneglycolmonomethyletheracetate, 6.6 g of cyclohexanone, and 0 g of polyoxyethylenealkylether were used.

### Comparative Experimental Example 8

A hardmask film was obtained in the same manner as in Experimental Example 1, except that 3.0 g of the polymer compound obtained in Example 1, 37.1 g of propyleneglycolmonomethyletheracetate, 9.4 g of cyclohexanone, and 0.5 g of polyoxyethylenealkylether were used.

### <Measurement of weight average molecular weight>

The weight average molecular weights obtained in Examples were measured through gel permeation chromatography (GPC). A WATERS GPC device was used for measurement, and the measurement conditions were as follows.

Column temperature: 40°C, Mobile phase: tetrahydrofuran (THF), flow rate: 1 mL/1 min, GPC column: STYRAGEL KF-801, 802, 803 (WATERS, 8X300 mm)

### <Test for property of coating thickness>

The thickness of the hardmask films formed in Examples 1 to 12 and Comparative Experimental Examples 1 to 8 were individually measured, and the results were shown in Table 1. A used device for measurement was Ellipsometer (Horiba).

**[Table 1]**

| | Sample | Coating Thickness (nm) | Coatability |
|---|---|---|---|
| Experimental Example 1 | Example 1 | 140 | Well-coated |
| Experimental Example 2 | Example 2 | 135 | Well-coated |
| Experimental Example 3 | Example 3 | 150 | Well-coated |
| Experimental Example 4 | Example 4 | 142 | Well-coated |
| Experimental Example 5 | Example 5 | 143 | Well-coated |
| Experimental Example 6 | Example 1 | 2,120 | Well-coated |
| Experimental Example 7 | Example 2 | 2,030 | Well-coated |
| Experimental Example 8 | Example 3 | 2,190 | Well-coated |
| Experimental Example 9 | Example 4 | 2,180 | Well-coated |
| Experimental Example 10 | Example 5 | 2,200 | Well-coated |
| Experimental Example 11 | Example 1 | 141 | Well-coated |
| Experimental Example 12 | Example 1 | 142 | Well-coated |
| Comparative Experimental Example 1 | Comparative Example 1 | 130 | Well-coated |
| Comparative Experimental Example 2 | Comparative Example 2 | 100 | Well-coated |
| Comparative Experimental Example 3 | Comparative Example 3 | 139 | Well-coated |
| Comparative Experimental Example 4 | Comparative Example 1 | 2,010 | Well-coated |
| Comparative Experimental Example 5 | Comparative Example 2 | 1, 910 | Well-coated |
| Comparative Experimental Example 6 | Comparative Example 3 | 2,350 | Poorly-coated |
| Comparative Experimental Example 7 | Example 1 | 2,300 | Poorly-coated |
| Comparative Experimental Example 8 | Example 1 | 138 | Well-coated |

When a hardmask film has a thickness in a range of 135 to 2,200, the coatability may be assessed to be good.

When the thickness of the hardmask films was assessed, in Experimental Examples 1 to 12, the thickness was measured to be in a range of 135 nm to 2,200 nm, and thus the sample films were assessed to have noticeable excellence in etching resistance as well as coatability.

Conversely, in Comparative Experimental Examples 1 and 2, the thickness was measured to be 130 nm and 100 nm, respectively, and thus the sample films were assessed to have a significantly deteriorated etching resistance, and in Comparative Experimental Examples 6 and 7, the thickness was measured to be 2,350 nm and 2,300 nm, respectively, and thus the coatability was assessed to have deteriorated since the physical properties of the coated surface were uneven.

Herein, in Comparative Experimental Example 8, a compound obtained in Example 1 was used, which meant the inclusion of 1% by weight of polyoxyethylenealkylether based on the total weight of the composition, and the thickness of the sample was measured to be 138 nm in the test for the property of coating thickness shown in Table 1 so that the coatability was assessed to be good.

### <Test for optical property>

The refractive index (n) and extinction coefficient (k) of the hardmask film formed in Experimental Examples 1 to 12 and Comparative Experimental Examples 1 to 8 were individually measured, and the results were shown in Table 2. A used device for measurement was Ellipsometer (Horiba).

**[Table 2]**

| | Sample | Refractive Index (n@193nm) | Extinction Coefficient (k@193nm) |
|---|---|---|---|
| Experimental Example 1 | Example 1 | 1.35 | 0.48 |
| Experimental Example 2 | Example 2 | 1.36 | 0.49 |
| Experimental Example 3 | Example 3 | 1.36 | 0.47 |
| Experimental Example 4 | Example 4 | 1.38 | 0.46 |
| Experimental Example 5 | Example 5 | 1.40 | 0.50 |
| Experimental Example 6 | Example 1 | 1.36 | 0.48 |
| Experimental Example 7 | Example 2 | 1.37 | 0.49 |
| Experimental Example 8 | Example 3 | 1.37 | 0.47 |
| Experimental Example 9 | Example 4 | 1.39 | 0.46 |
| Experimental Example 10 | Example 5 | 1.41 | 0.50 |
| Experimental Example 11 | Example 1 | 1.35 | 0.48 |
| Experimental Example 12 | Example 1 | 1.35 | 0.48 |
| Comparative Experimental Example 1 | Comparative Example 1 | 1.44 | 0.68 |
| Comparative Experimental Example 2 | Comparative Example 2 | 1.44 | 0.69 |
| Comparative Experimental Example 3 | Comparative Example 3 | 1.45 | 0.67 |
| Comparative Experimental Example 4 | Comparative Example 1 | 1.45 | 0.68 |
| Comparative Experimental Example 5 | Comparative Example 2 | 1.45 | 0.69 |
| Comparative Experimental Example 6 | Comparative Example 3 | - | - |
| Comparative Experimental Example 7 | Example 1 | - | - |
| Comparative Experimental Example 8 | Example 1 | 1.35 | 0.48 |

The refractive index (n@193nm) and extinction coefficient (k@193nm) of the hardmask film were measured as shown in Table 2 other than those of Comparative Experimental Examples 6 and 7 which had not been able to be measured due to the deteriorated coatability of the samples.

When the refractive index (n@193nm) of the hardmask film is 1.41 or less, and when the extinction coefficient (k@193nm) is 0.50 or less, the refractive index and extinction coefficient may be assessed to be excellent, respectively.

First, when the refractive index (n@193nm) of the hardmask film was assessed, the measured refractive index (n@193nm) was in a range of 1.35 to 1.41 in Experimental Examples 1 to 12 while the measured refractive index (n@193nm) was in a range of 1.44 to 1.45 in Comparative Experimental Examples 1 to 5 (Comparative Experimental Examples 6 and 7 were excluded due to their deteriorated coatability), and thus it was able to identify that the property of refractive index (n@193nm) in Experimental Examples 1 to 12 was excellent.

Second, when the extinction coefficient (k@193nm) of the hardmask film was assessed, the measured extinction coefficient (k@193nm) was in a range of 0.46 to 0.50 in Experimental Examples 1 to 12 while the measured extinction coefficient (k@193nm) was in a range of 0.67 to 0.69 in Comparative Experimental Examples 1 to 5 (Comparative Experimental Examples 6 and 7 were excluded due to their deteriorated coatability), and thus it was able to identify that the property of extinction coefficient (k@193nm) in Experimental Examples 1 to 12 was significantly excellent.

Herein, in Comparative Experimental Example 8, a compound obtained in Example 1 was used, which meant the inclusion of 1% by weight of polyoxyethylenealkylether based on the total weight of the composition, and the refractive index (n@193nm) and extinction coefficient (k@193nm) of the hardmask film were assessed to be excellent with the measurements of 1.35 and 0.48, respectively.

### <Test for property of evaporation loss>

A test for the property of evaporation loss over the hardmask films formed in Experimental Examples 1 to 12 and Comparative Experimental Examples 1 to 8 was conducted. Weight loss was measured at a temperature of 400°C through TGA (Thermal Analyzer System, TA Instrument) which was a device for measurement, and the results were shown in Table 3.

**[Table 3]**

| | Sample | Weight loss(400°C) |
|---|---|---|
| Experimental Example 1 | Example 1 | 3.0% |
| Experimental Example 2 | Example 2 | 3.0% |
| Experimental Example 3 | Example 3 | 3.0% |
| Experimental Example 4 | Example 4 | 3.0% |
| Experimental Example 5 | Example 5 | 3.0% |
| Experimental Example 6 | Example 1 | 3.0% |
| Experimental Example 7 | Example 2 | 3.0% |
| Experimental Example 8 | Example 3 | 3.0% |
| Experimental Example 9 | Example 4 | 3.0% |
| Experimental Example 10 | Example 5 | 3.0% |
| Experimental Example 11 | Example 1 | 3.0% |
| Experimental Example 12 | Example 1 | 3.0% |
| Comparative Experimental Example 1 | Comparative Example 1 | 10.0% |
| Comparative Experimental Example 2 | Comparative Example 2 | 11.0% |
| Comparative Experimental Example 3 | Comparative Example 3 | 9.5% |
| Comparative Experimental Example 4 | Comparative Example 1 | 10.0% |
| Comparative Experimental Example 5 | Comparative Example 2 | 11.0% |
| Comparative Experimental Example 6 | Comparative Example 3 | - |
| Comparative Experimental Example 7 | Example 1 | - |
| Comparative Experimental Example 8 | Example 1 | 4.0% |

When the evaporation loss property of a hardmask film is tested through TGA according to conventional arts, the weight loss is known to be 4% or more at a temperature of 400°C so when weight loss is less than 4%, it may be defined as excellent, and when weight loss is 3% or less, it may be defined as very excellent.

The measured evaporation loss was 3% in Experimental Examples 1 to 12 while it was in a range of 4% to 11% in Comparative Experimental Examples 1 to 8. Thus, the evaporation loss property in Experimental Examples 1 to 12 was able to be identified to be very excellent.

The foregoing has described in detail certain aspects of the present disclosure, and thus it will be apparent to one of ordinary skill in the art that these specific descriptions are merely preferred embodiments and are not intended to limit the scope of the present disclosure. Accordingly, the substantial scope of the present disclosure will be defined by the claims and their equivalents.

## Claims

1. A spin-on carbon hardmask composition comprising a polymer having a structure represented by Formula 1 shown below and having a weight average molecular weight in a range of 1,500 to 20,000, the composition exhibiting a small evaporation loss when baked at a temperature of 400°C. 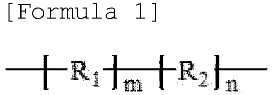
wherein in Formula 1, m and n are in ranges of 1≤m≤50 and 1≤n≤50, respectively,
R₁ comprises any one of 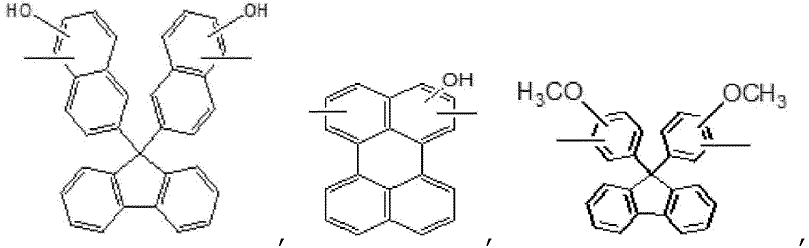 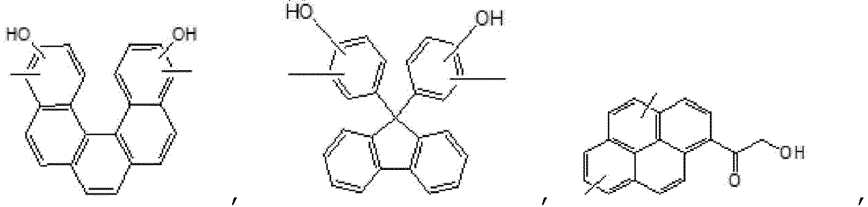 and 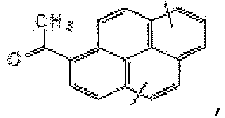 and
R₂ comprises any one of

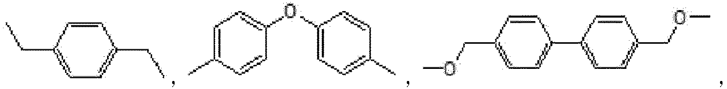

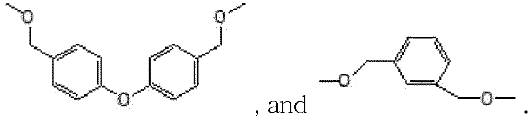

2. The spin-on carbon hardmask composition of claim 1, wherein the composition comprises the polymer represented by Formula 1, a surfactant, and an organic solvent.

3. The spin-on carbon hardmask composition of claim 2, wherein the polymer, surfactant, and organic solvent account for 1% to 50% by weight, 0.01% to 0.1% by weight, and 50% to 98.99% by weight, respectively based on the total weight of the composition.

4. The spin-on carbon hardmask composition of claim 3, wherein the evaporation loss is in a range of 2.5% to 3.5%.

5. The spin-on carbon hardmask composition of claim 4, wherein the evaporation loss is in a range of 2.7% to 3.2%.

6. The spin-on carbon hardmask composition of claim 5, wherein the evaporation loss is in a range of 2.9% to 3.1%.

7. The spin-on carbon hardmask composition of claim 6, wherein the coating thickness of a hardmask film is in a range of 135 nm to 2,200nm.

8. The spin-on carbon hardmask composition of claim 3, wherein the surfactant is one or a mixture of two or more selected from the group consisting of polyoxyethylenealkylethers, polyoxyethylenealkylphenylethers, polyoxyethylenenonylphenylethers, polyoxyethylene octylphenylethers, polyoxyethylenepolyoxypropylenes, polyoxyethylenelaurylethers, and polyoxyethylenesorbitans.

9. The spin-on carbon hardmask composition of claim 3, wherein the organic solvent is one or a mixture of two or more selected from the group consisting of propylenecyclocholomonomethylethers (PGMEs), propyleneglycolomonomethylether acetates (PGMEAs), cyclohexanone, cyclopentanones, γ-butyrolactones, ethyllactates (ELs), methylethylketones, n-butylacetates, N-methylpyrrolidones (NMPs), methyl 3-methoxypropionates (MMPs), and ethyl 3-ethoxypropionates (EEPs) .

10. The spin-on carbon hardmask composition of claim 1, wherein the weight average molecular weight of the polymer is in a range of 1,500 to 15,000.

11. The spin-on carbon hardmask composition of claim 10, wherein the weight average molecular weight of the polymer is in a range of 1,500 to 10,000.

12. A patterning method comprising:
applying the composition of any one of claims 1 to 11 to a surface of a layer to be etched, through spin coating; and
baking the composition to form a hardmask layer.

13. The patterning method of claim 12, wherein the baking is performed at a temperature in a range of 150°C to 400°C for 1 minute to 5 minutes to form the hardmask layer.
